**Europäisches Patentamt**

**European Patent Office**

**Office européen des brevets**

(19)

(11) Veröffentlichungsnummer: **0 368 809**

**A1**

(12) # EUROPÄISCHE PATENTANMELDUNG

(21) Anmeldenummer: **89810835.2**

(22) Anmeldetag: **06.11.89**

(51) Int. Cl.5 **H05K 3/46, B23Q 3/18, B29C 65/60, F16B 19/08, H05K 13/00**

(30) Priorität: **11.11.88 CH 4190/88**

(43) Veröffentlichungstag der Anmeldung:
**16.05.90 Patentblatt 90/20**

(84) Benannte Vertragsstaaten:
**AT BE CH DE ES FR GB GR IT LI LU NL SE**

(71) Anmelder: **FELA PLANUNGS AG**
**Täfernstrasse 11**
**CH-5405 Baden-Dättwil(CH)**

(72) Erfinder: **Züst, Harry, Dr. sc. Dipl.-Ing. Chem. ETH**
**Weinbergstrasse 58**
**CH-8703 Erlenbach(CH)**

(74) Vertreter: **Frauenknecht, Alois J. et al**
**c/o PPS Polyvalent Patent Service AG,**
**Mellingerstrasse 1**
**CH-5400 Baden(CH)**

(54) **Verfahren zur Positionierung und Fixierung von Mehrlagenschaltungen sowie Mittel und Vorrichtung zur Durchführung des Verfahrens.**

(57) Beim Heisspressen von Mehrlagenschaltungen mit einem evakuierten Beutel stellt sich das Problem, die Schaltungsplatten ohne vorstehende Teile passgenau aufeinander zu legen und zu fixieren.

Es wird nun ein neues Verfahren zur Positionierung und Fixierung von mehreren Schaltungsplatten (6,7,8,9,10) vorgestellt, bei welchem Gleitkörper (1) aus thermoplastischem Material in seiner Breite formschlüssig in Langlöcher der Platten (6,7,8,9,10) eingeführt und umgeformt werden. Die Schaltungsplatten (6,7,8,9,10) sind am Gleitkörper (1) längsverschiebbar, so dass Wärmeausdehnungen kompensiert werden.

Der Gleitkörper (1) ist in der Länge zylindrisch ausgebildet mit zwei Gleitflächen (3) und einer durchgehenden zentralen Bohrung (2).

Das Werkzeug zur Umformung des Gleitkörpers (1) weist ein zylindrisches Heizelement auf, mit einer zentralen Bohrung, in welcher ein Zentrierstift vorgesehen ist. Das Heizelement ist von einem Anpressrohr umgeben, das in einer Hülse gegen eine Anpressfeder verschiebbar ist.

Fig.1a  Fig.1b  Fig.1c

# Verfahren zur Positionierung und Fixierung von Mehrlagenschaltungen sowie Mittel und Vorrichtung zur Durchführung des Verfahrens

Die vorliegende Erfindung bezieht sich auf ein Verfahren zur Positionierung und Fixierung von Mehrlagenschaltungen in einem Heisspressverfahren, wobei mehrere Schaltungsplatten in ihrem Schaltbild deckungsgleich gestapelt werden, und wobei im Randbereich der Platten Langlöcher vorgesehen sind sowie auf ein Mittel zur Durchführung des Verfahrens und eine Vorrichtung zum Einsatz des Mittels.

Mehrlagige Schaltungsplatten werden im Vakuum verpresst und miteinander verklebt zu sogenannten Multilayers. Unter der Handelsbezeichnung "Multiklav" wird von der Firma Fela Planungs AG eine Vorrichtung angeboten. bei welcher aufeinandergeschichtete Schaltungsplatten in einem Beutel aus einem geeigneten Elastomer durch eine Hydraulikflüssigkeit bei Temperaturen um 180° C und bei einem Druck von 25 bar während 20 bis 30 Minuten verpresst werden, vgl. EP -A1- 0 297 027.

Es hat sich in praxi gezeigt, dass die im "Multiklav" verwendeten Elastomerbeutel an den durch Bolzen zusammengehaltenen Stellen der Stapel der Schaltungsplatten in diesem Verfahren hohen mechanischen Belastungen ausgesetzt sind und deshalb vorzeitig verschleiss.

Es ist Aufgabe der Erfindung, ein Verfahren und Mittel zur Durchführung des Verfahrens zu schaffen, welche die Standzeit der Beutel erheblich verbessern und die Gefahr von durch Hydrauliköl verschmutzen Platten minimalisieren.

Erfindungsgemäss ist das Verfahren dadurch gekennzeichnet, dass je ein Gleitkörper, aus thermoplastischem Material, mit einem endseitigen Flansch, in seiner Breite formschlüssig in das Langloch eingeführt wird und dass dieser Gleitkörper in seinen den Stapel überragenden Teil derart umgeformt wird, dass die Schaltungsplatten am Gleitkörper längsverschiebbar sind und sich Wärmedehnungen in den Platten ausgleichen und/oder kompensieren.

Die gestapelten Schaltungsplatten können sich dabei auch bei hohen Temperaturen ausdehnen, ohne dass sich diese gegenseitig verwerfen und/oder verschieben.

Vorteilhafte Weiterbildungen und Mittel zur Durchführung des Verfahrens sind in den nachfolgenden abhängigen Ansprüchen beschrieben.

Durch die Verwendung eines Thermoplasts als Gleitkörper lässt sich dieser in einfachster Weise durch thermisches Umbördeln mechanisch auf dem Plattenstapel sichern und gewährleistet zudem eine gute Längsverschiebbarkeit der Platten, vgl. Anspruch 2.

Eine bevorzugte Ausführung eines Gleitkörpers weist gemäss Anspruch 3 eine zentrale Bohrung und zwei parallele Gleitflächen auf.

An sich sind beliebige thermoplastische Kunststoffe als Gleitkörper verwendbar, doch erfordern die hohen Temperaturen und Drucke eine Formbeständigkeit von mindestens 170° C, welche nach Vicat gemessen wird.

Bewährt haben sich vor allem Kunststoffe aus Polyamid, Polyimid oder Polysulfon, Anspruch 5.

Die Gleitkörper werden in bevorzugter Weise mit einer Vorrichtung nach Anspruch 6 gebördelt.

Diese Vorrichtung ist besonders einfach zu handhaben, wenn sie eine längsverschiebbare Hülse, entsprechend Anspruch 7, aufweist.

Ein Zentrierstift aus Graphit, nach Anspruch 8, gewährleistet eine saubere und mechanisch einwandfreie Bördelung. ohne dass deren Höhe den Elastomerbeutel mechanisch belastet.

Ein sauberes Verpressen erfolgt in einfacher Weise durch ein Anpressrohr nach Anspruch 9, welches durch seine Materialeigenschaften sein Verkleben verhindert.

Eine mechanisch einfach zu handhabende Konstruktion basiert auf in der Längsverschiebung direkt auf der Heizpatrone mittels Schrauben begrenzbaren Hülse, gemäss Anspruch 10.

Nachstehend wird die Erfindung anhand in den Zeichnungen dargestellter Ausführungsbeispiele näher beschrieben. Es zeigt:

Fig. 1a ein Gleitkörper,

Fig. 1b derselbe Gleitkörper in Schnittdarstellung längs der Linie A-A in Fig. 1a,

Fig. 1c derselbe Gleitkörper mit Schaltungsplatten,

Fig. 2 eine Draufsicht mehrerer mit Gleitkörpern zusammengehaltener Schaltungsplatten und

Fig. 3 ein Werkzeug zum Umformen des Gleitkörpers.

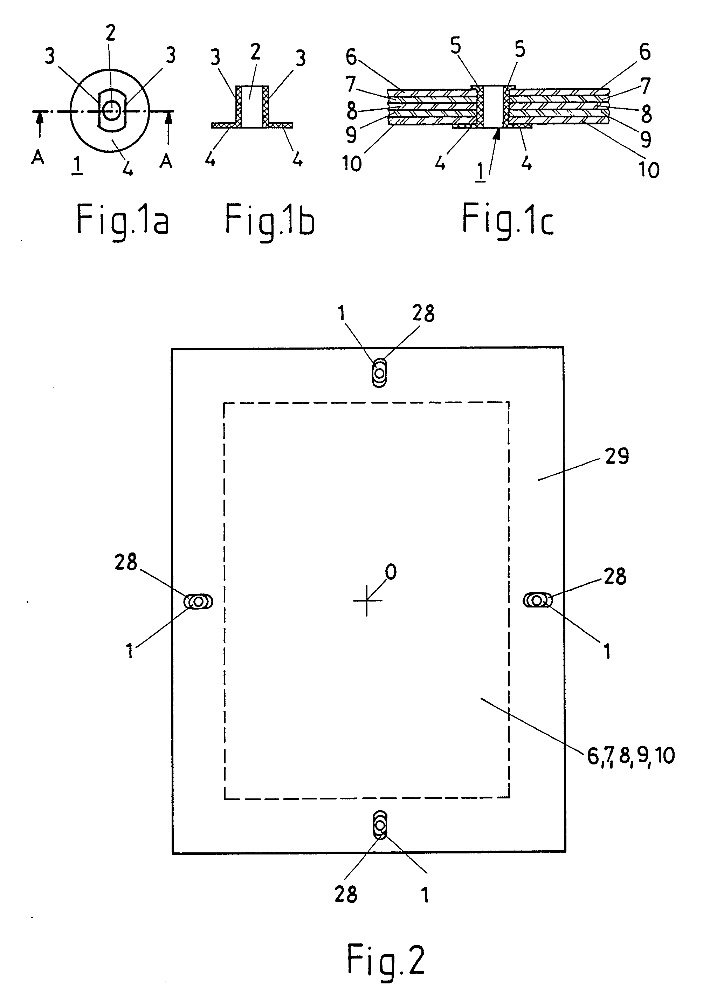

In Fig. 1a ist ein Gleitkörper 1 in Draufsicht dargestellt, der in seiner Länge zylindrisch ausgebildet ist und in seiner Mitte eine zentrale durchgehende Bohrung 2 aufweist. Der aufstehende zylindrische Teil ist mit zwei parallelen, abgeplatteten Gleitflächen 3 versehen (Fig.1b). Unten am zylindrischen Teil des Gleitkörpers 1 ist ein sehr dünner Flansch 4 angeordnet. Fig. 1c zeigt mehrere Schaltungsplatten 6 bis 10, die mit einem Gleitkörper 1 zusammengefasst sind, wozu der obere Rand des zylindrischen Teils zu einem Kragen 5 umgeformt ist.

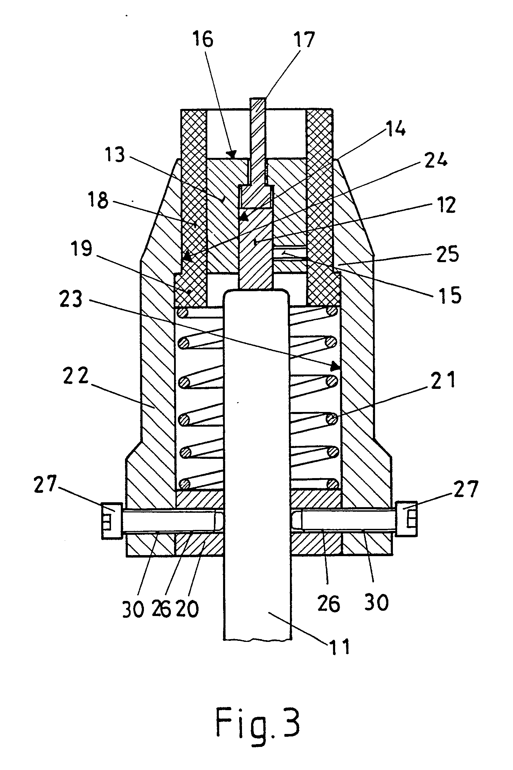

In Fig. 3 wird ein Werkzeug gezeigt, mit welchem der Gleitkörper 1 besonders zweckmässig und einfach umgeformt werden kann. Auf dem Ende einer handelsüblichen Heizpatrone 11 ist ein Kupfereinsatz 12 vorgesehen. Die Heizleistung der Heizpatrone 11 beträgt 50 Watt und ist in üblicher Weise einstellbar. Auf dem Kupfereinsatz 12 ist ein zylindrisches Heizelement 13 aus einem Vanadium legierten Stahl wie V2A oder V4A aufgesteckt, welches zentral eine stufenförmige Bohrung 14 aufweist. Das Heizelement 13 ist mit einer Innensechskantschraube 15 auf dem Kupfereinsatz 13 festgeschraubt, wobei die Schraube 15 nicht über das Heizelement 13 hinausragt. Das obere Ende des Heizelements 13 bildet eine ringförmige Heizfläche 16, deren Öffnung ein Zentrierstift 17 umfasst, der über die Heizfläche 16 hinausragt und dessen Form der Bohrung 14 entspricht. Der Zentrierstift 17 besteht aus einem Material geringerer Wärmeleitfähigkeit als die der Heizfläche 16 und besteht insbesondere aus Graphit. Es kann jedoch auch ein Isolator wie Aluminiumoxid verwendet werden. Über das Heizelement 13 ist ein Anpressrohr 18 geschoben, welches am unteren Ende ein Flansch 19 aufweist. Das Anpressrohr 18 besteht aus kohlenverstärktem Polytetrafluorethylen (PTFE) und ist somit bis über 300° C wärmebeständig. Weiter unten an der Heizpatrone 11 ist ein zylindrischer Ringkörper 20 angeordnet, der als Stütze für eine Anpressfeder 21 dient, die das Anpressrohr 18 nach oben zu drücken versucht. Der Ringkörper 20 besteht aus einer Aluminium-Magnesium-Legierung ("Anticorodal"). Über das Anpressrohr 18 und den Ringkörper 20 ist eine Hülse 22 aus Messing geschoben, die eine erste grössere Innenbohrung 23 und eine zweite kleinere Innenbohrung 24 aufweist, so dass sich im oberen Bereich ein Anschlag 25 ergibt. Die erste Bohrung 23 entspricht dem Durchmesser des Ringkörpers 20 und des Flansches 19, und die zweite Bohrung 24 entspricht dem Durchmesser des oberen Teiles des Anpressrohrs 18. Im Ringkörper 20 sind zwei gegenüberliegende Gewindebohrungen 26 vorgesehen, und genau dementsprechend zwei Gewindebohrungen 26 in der Hülse 22. Die letzteren können aber auch normale Bohrungen mit demselben Durchmesser wie die Gewindebohrungen 26 sein. Die Hülse 22 und der Ringkörper 20 sind mittels zwei Innensechskantschrauben 27, die in den Gewindebohrungen 26 eingeschraubt sind, auf der Heizpatrone 11 befestigt. Der Abstand zwischen der oberen Kante des Anpressrohrs 18 und der Heizfläche 16 kann durch Verschieben des Ringkörpers 20 und der Hülse 22 eingestellt werden.

Fig. 2 zeigt mehrere Platten 6 bis 10, welche Innenlagen und wechselsweise Verbundfolien eines Multilayers sind, die von Gleitkörpern 1 zusammengehalten werden. Die Gleitkörper 1 sind in Langlöcher 28 zusammengepresst, die sich im Randbereich 29 der Schaltungsplatten 6 bis 10 befinden. Sie bestehen aus einem Thermoplast mit einem schmelzpunktartigen Fliessbereich von mindestens 180° C und einer Formbeständigkeit nach Vicat von mindestens 170° C. Besonders geeignet sind somit Polyamid, Polyimid und Polysulfon. Das Zusammenpressen oder Umformen der Gleitkörper 1 wird mit dem in Fig. 3 beschriebenen Werkzeug wie folgt durchgeführt:

Das Anpressrohr 18 wird über den Gleitkörper 1 aufgesetzt, und dann wird die Heizpatrone 11 mit dem Zentrierstift 17 in die zentrale Bohrung 2 des Gleitkörpers 1 gedrückt, so dass die Heizfläche 16 den oberen Rand des Gleitkörpers 1 zu einem Kragen 5 umformt (Fig. 1c). Sodann wird die Patrone 11 geringfügig losgelassen, so dass die Heizfläche 16 den Gleitkörper 1 nicht mehr berührt, jedoch das Anpressrohr 18 die Schaltungsplatten 6 bis 10 immer noch zusammendrückt. Damit kann der umgeformte Gleitkörper 1 abkühlen und einen genügend grossen Zusammenhalt für die Schaltungsplatten 6 bis 10 bilden.

Da die Gleitkörper 1 eine hohe Formstabilität aufweisen während des Heisspressverfahrens, insbesondere in einem isostatischen Pressverfahren in einem Autoklav, wobei die zusammengehaltenen Schaltungsplatten 6 bis 10 in einen ständig evakuierten Beutel hineingesteckt sind, fliesst das Epoxidharz der Platten 6 bis 10 um die Gleitkörper 1, ohne sich mit diesen zu binden, wie es sonst bei metallischen Bolzen oft vorkommt. Da die Langlöcher 28 alle auf den Mittelpunkt (Achsenkreuz) der Platten 6 bis 10 ausgerichtet sind, können Wärmedehnungen in diese Richtung ausgeglichen und/oder kompensiert werden. Damit können Verschiebungen der Schaltbilder zueinander verhindert werden. Dies ist von grösster Bedeutung, da die Schaltungsplatten 6 bis 10 stets eine geringe Welligkeit vorweisen, die normalerweise beim Zusammenpressen zu Verschiebungen und Verwerfungen führt. Nach dem Heisspressen werden die Gleitkörper 1 mit einer Art Lochzange oder mit einem Durchschlag aus den Langlöchern 28 herausgenommen, welche nun ein perfektes Abbild der Gleitkörper 1 formen. Damit wird ein gleiches Referenzsystem für das Bohrmuster und zum Ätzen des oberen und/oder unteren Leiterbildes der derart hergestellten Mehrlagenschaltung geschaffen.

Selbstverständlich können anstelle der derzeit zum Verkleben verwendeten Epoxi-Verbundfolien ("Prepregs") auch den spezifischen Schaltungsplatten bzw. Anordnungen angepasste andere Kleber verwendet werden. Die erfindungsgemässe Lehre lässt sich analog anwenden.

Ebenso kann die als Handwerkzeug ausgebildete Vorrichtung zum Umformen der Gleitkörper auch maschinell eingesetzt werden, beispielsweise in Verbindung mit einer Positionier- und Stanzeinrichtung.

Ansprüche

1. Verfahren zur Positionierung und Fixierung von Mehrlagenschaltungen in einem Heisspressverfahren, wobei mehrere Schaltungsplatten in ihrem Schaltbild deckungsgleich gestapelt werden, und wobei im Randbereich der Platten Langlöcher vorgesehen sind, dadurch gekennzeichnet, dass je ein Gleitkörper, aus thermoplastischem Material, mit einem endseitigen Flansch, in seiner Breite formschlüssig in das Langloch eingeführt wird und dass dieser Gleitkörper in seinen den Stapel überragenden Teil derart umgeformt wird, dass die Schaltungsplatten am Gleitkörper längsverschiebbar sind und sich Wärmedehnungen in den Platten ausgleichen und/oder kompensieren. (Fig.2)

2. Verfahren nach Anspruch 1, dadurch gekennzeichnet, dass der Gleitkörper mittels eines beheizten Werkzeugs in seinen den Stapel überragenden Teil thermisch, kragenförmig umgeformt wird. (Fig.1)

3. Mittel zur Durchführung des Verfahrens nach Anspruch 1, dadurch gekennzeichnet, dass der Gleitkörper (1) in seiner Länge zylindrisch ausgebildet ist und zwei einander gegenüberliegende, zueinander parallele Gleitflächen (3) und eine durchgehende zentrale Bohrung (2) aufweist. (Fig.1)

4. Mittel nach Anspruch 3, dadurch gekennzeichnet, dass der Gleitkörper (1) aus einem thermoplastischen Kunststoff besteht mit einem schmelzpunktartigen Fliessbereich von mindestens 180°C und mit einer Formbeständigkeit von mindestens 170°C. (Fig.1)

5. Mittel nach Anspruch 4, dadurch gekennzeichnet, dass der thermoplastische Kunststoff Polyamid, Polyimid oder Polysulfon ist. (Fig.1)

6. Vorrichtung zur Durchführung des Verfahrens nach Anspruch 1, dadurch gekennzeichnet, dass ein zylindrisches Heizelement (13) mit einer zentralen Bohrung (14) vorgesehen ist, in welcher ein Zentrierstift (17) angeordnet ist, und dass das Heizelement (13) von einem Anpressrohr (18) umgeben ist, welches in einer Hülse (22) gegen eine Anpressfeder (21) verschiebbar gelagert ist. (Fig.3)

7. Vorrichtung nach Anspruch 6, dadurch gekennzeichnet, dass die Hülse (22) an dem dem Heizelement (13) gegenüberliegenden Ende mit einem zylindrischen Ringkörper (20) verschiebbar auf einer Heizpatrone (11) befestigt ist, und dass das Anpressrohr (18) aus einem hitzebeständigen Kunststoff besteht und einen Flansch (19) aufweist und am anderen Ende der Hülse (22) ein Anschlag (25) vorgesehen ist, an welchem der Flansch (19) ansteht. (Fig.3)

8. Vorrichtung nach Anspruch 7, dadurch gekennzeichnet, dass der Zentrierstift (17) aus Graphit besteht. (Fig.3)

9. Vorrichtung nach Anspruch 7, dadurch gekennzeichnet, dass das Anpressrohr (18) aus einem graphitverstärkten Polytetrafluorethylen besteht. (Fig.3)

10. Vorrichtung nach Anspruch 7, dadurch gekennzeichnet, dass der zylindrische Ringkörper (20) und die Hülse (22) Gewindebohrungen (26) aufweisen, in denen Schrauben (27) zur Einstellung der Längsverschiebung der Hülse auf der Heizpatrone (11) eingreifen. (Fig.3)

Fig.1a

Fig.1b

Fig.1c

Fig.2

13 121 PPS/Sp

16    17

13    14

18    24

19    12

23    25

22    15

27    21

27

30 26 20    26   30

11

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-2 252 163 (IBM DEUTSCHLAND GMBH) * Ansprüche 1-4; Figuren 1-3c * | 1 | H 05 K 3/46 B 23 Q 3/18 B 29 C 65/60 F 16 B 19/08 H 05 K 13/00 |
| A | US-A-4 598 453 (T. M. WILLS) * Zusammenfassung; Spalte 2, Zeile 56 - Spalte 3, Zeile 51; Figuren 1-4 * | 1 | |
| A | US-A-3 917 983 (J. M. KURONEN) * Spalte 2, Zeile 27 - Spalte 3, Zeile 19; Figuren 1,2 * | 1 | |
| A | EP-A-0 167 867 (PRESIDENT ENGINEERING CORP.) * Seite 10, Zeile 25 - Seite 11, Zeile 6; Seite 11, Zeile 32 - Seite 12, Zeile 33; Figuren 1,2 * | 1-3 | |
| A | US-A-3 754 310 (G.J. SHEA) * Spalte 4, Zeile 5 - Spalte 5, Zeile 26; Anspruch 1; Figuren 2,3 * | 1-5 | |
| A | GB-A- 555 151 (SIDNEY JOHN HENRY DEX) * Seite 6, Zeile 90 - Seite 7, Zeile 72; Figuren 1-6 * | 4-10 | **RECHERCHIERTE SACHGEBIETE (Int. Cl.5)** B 29 C H 05 K B 23 Q F 16 B B 21 J H 05 K |

Der vorliegende Recherchenbericht wurde für alle Patentansprüche erstellt

| Recherchenort | Abschlußdatum der Recherche | Prüfer |
|---|---|---|
| BERLIN | 01-02-1990 | CUNY J M J C |